# EUROPÄISCHE PATENTSCHRIFT

(11) **EP 3 328 536 B1**
(45) Veröffentlichungstag und Bekanntmachung des Hinweises auf die Patenterteilung: **10.12.2025**
(21) Anmeldenummer: 16745622.7
(22) Anmeldetag: 26.07.2016
(51) Int. Cl.: B01J 19/00, B01J 19/20, B01J 19/28, B01J 4/00, C30B 7/08, C30B 7/14, B01D 9/00

(54) **VERWENDUNG EINES KRISTALLISATORS ZUR ZÜCHTUNG VON KRISTALLEN**
USE OF A CRYSTALLIZER FOR CONTINUOUSLY GROWING CRYSTALS
UTILISATION D'UN CRISTALLISATEUR DE CROISSANCE CONTINUE DE CRISTAUX

(30) Priorität: 29.07.2015 DE 102015009754
(43) Veröffentlichungstag der Anmeldung: 06.06.2018
(73) Patentinhaber: Heitmann, Torsten, 79539 Lörrach (DE); Wilk, Andreas, 4057 Basel (CH)
(72) Erfinder: Heitmann, Torsten, 79539 Lörrach (DE); Wilk, Andreas, 4057 Basel (CH)
(74) Vertreter: Lorenz Seidler Gossel Part. mbB
(86) Internationale Anmeldenummer: PCT/EP2016/001292
(87) Internationale Veröffentlichungsnummer: WO 2017/016659

(56) Entgegenhaltungen:
- EP-B1- 0 229 139
- DE-A1- 102008 058 313
- GB-A- 491 945
- US-A- 2 624 552
- US-A- 2 995 016
- US-A- 3 595 625
- US-A- 3 652 230
- US-A1- 2009 012 649
- US-A1- 2014 234 177

## Beschreibung

Die Erfindung betrifft Verwendung eines Kristallisators zur Züchtung von Kristallen.

In einer Vielzahl von industriellen Anwendungen ist die Züchtung von Kristallen aus einem fluiden Kristallisationsmedium wie beispielsweise einer Lösung oder einer Schmelze erforderlich. Meist erfolgt die Züchtung von Kristallen in diskontinuierlichen Prozessen, die mit einem erhöhten Zeit- und Kostenaufwand verbunden sind.

US 2995016 A offenbart einen Kristallisator zur Trennung von Komponenten aus einer Flüssigkeit durch fraktionierte Kristallisation: der Kristallisator weist einen horizontal gelagerten Rohr auf, wobei ein helixförmig um eine Längsachse des Rohres verlaufender und an der Innenseite des Rohrmantels anliegender Steg vorgesehen ist, der fest mit der Innenseite des Rohrmantels verbunden ist, wobei das Rohr gemeinsam mit dem Steg um die Längsachse rotiert. US 2624552 A und GB 491954 A offenbaren horizontal gelagerte Rohrkristallisatoren mit einem helixförmigen um eine Längsachse des Rohres verlaufenden Steg.

Ziel der Erfindung ist es, eine Verwendung eines Kristallisators zur Züchtung von Kristallen im Rahmen eines kontinuierlichen Prozesses bereitzustellen.

Vor diesem Hintergrund betrifft die Erfindung die Verwendung eines Kristallisators zur Züchtung von Kristallen gemäß Anspruch 1, wobei der Kristallisator ein Rohr aufweist, an dessen gegenüberliegenden Endbereichen ein Zulauf und ein Ablauf für ein Kristallisationsmedium vorgesehen sind, wobei ein helixförmig um eine Längsachse des Rohres verlaufender und an der Innenseite des Rohrmantels anliegender Steg vorgesehen ist, wobei der Steg derart gelagert ist, dass er um die genannte Längsachse des Rohres gedreht werden kann, und wobei der Kristallisator einen Antrieb zur Drehung des Stegs aufweist.

Vorzugsweise ist das Rohr im Querschnitt kreisförmig. Die Drehachse entspricht der genannten Längsachse des Rohres und verläuft vorzugsweise im Mittelpunkt des im Querschnitt gebildeten Kreises.

Geeignete Antriebe umfassen Motoren wie beispielsweise Elektromotoren.

Die Einbaulage des Rohres ist horizontal.

Das Rohr und/oder der Steg sind vorzugsweise aus schweißbaren Materialien wie beispielsweise Metall oder Kunststoff gefertigt. Auch Materialien wie Glas, Kohlenstoff, faserverstärkte Kunststoffe oder Keramik - wie beispielsweise Emaille - eignen sich für den Einsatz. In einer Ausführungsform sind die Innenseite des Rohrmantels und/oder der Steg beschichtet, beispielsweise mit einem korrosionsbeständigen Material wie Teflon.

In der vorliegenden Erfindung ist der Steg fest mit der Innenseite des Rohrmantels verbunden. Beispielsweise kann der Steg an der Innenseite des Rohrmantels angeschweißt oder angeklebt sein.

In der vorliegenden Erfindung ist das Rohr derart gelagert, dass es gemeinsam mit dem Steg um die genannte Längsachse rotiert werden kann. In diesem Fall stellt die drehbare Lagerung des Rohres die drehbare Lagerung des Stegs dar und dient der Antrieb zur Drehung des Rohres.

In einer Ausführungsform ist stellen der Steg und das Rohr separate Bauteile dar.

In einer Ausführungsform ist das ablaufseitige Ende des Rohres verschlossen. Das Verschließen kann beispielsweise anhand einer Blende erfolgen.

In einer Ausführungsform weist der Rohrmantel im ablaufseitigen Endbereich einen oder mehrere über den Umfang verteilte Durchbrüche auf. Die Durchbrüche ermöglichen einen Abfluss des Kristallisationsmediums aus dem Rohrinneren. Sie können gleichmäßig über den Umfang des Rohres verteilt sein und/oder alle auf derselben Längenposition des Rohres angeordnet sein. Beispielsweise handelt es sich bei den Durchbrüchen um kreisförmige Bohrungen.

An den Ablauf können ein Sammler wie beispielsweise statische Sammler und/oder Trennvorrichtungen wie beispielsweise Zentrifugen, Filter und/oder Dekanter anschließen.

In einer Ausführungsform weist das zulaufseitige Ende des Rohres eine Zugangsöffnung auf. Die Zugangsöffnung ermöglicht einen Zufluss des Kristallisationsmediums in das Rohrinnere. Das zulaufseitige Ende des Rohres kann entweder unverblendet sein oder mit einer Blende versehen sein, die eine Zugangsöffnung aufweist. Beispielsweise kann vorgesehen sein, dass eine zulaufseitige Blende einen entlang der Mantelfläche des Rohres verlaufenden Damm bildet und im Zentrum eine Zugangsöffnung aufweist. Der Damm ist vorzugsweise an allen Stellen wenigstens gleich hoch oder höher als der helixförmige Steg. Die Zugangsöffnung kann beispielsweise kreisförmig sein, wobei der Kreismittelpunkt der Drehachse des Rohres entsprechen kann.

Der Zulauf kann eine Leitung umfassen, die am zulaufseitigen Ende des Rohres in das Rohr hineinragt. Vorzugsweise ist der Zulauf stationär, d.h. nicht drehbar gelagert, sodass er im Betrieb des Kristallisators nicht mit dem Rohr mitgedreht wird.

In einer Ausführungsform umfasst der Kristallisator wenigstens eine Lanze, die in axialer Richtung von einem Ende des Rohres und vorzugsweise ausgehend vom zulaufseitigen Ende des Rohres in das Rohrinnere ragt. Die Lanze weist wenigstens einen Sensor und/oder wenigstens einen Aktor auf.

Bei dem Aktor kann es sich beispielsweise um ein Mittel zur Flüssigkeitsabgabe wie eine Düse oder dergleichen handeln. Die Lanze kann so gelagert sein, dass diese in axialer Richtung bewegt werden kann. So ist es möglich, die Lanze aus dem Rohrinneren zu ziehen, in das Rohrinnere einzuführen und innerhalb des Rohrinneren in axiale Richtung zu bewegen. Alternative oder zusätzlich kann die Lanze so gelagert sein, dass diese in radialer Richtung bewegt werden kann. Beispielsweise kann eine Kipplagerung der Lanze vorgesehen sein, sodass die Lanze aus der axialen Richtung gekippt und so die Spitze der Lanze angehoben werden kann. So ist es möglich, die an der Lanze befindlichen Sensoren oder Aktoren in vertikaler Richtung zu bewegen und den Sensor beispielsweise in periodischen Abständen zu heben, um eine Kollision mit dem sich durch die Drehung des Rohres verschiebenden Steg zu vermeiden. Vorzugsweise ist die Lanze stationär, d.h. nicht drehbar gelagert sind, sodass sie im Betrieb des Kristallisators nicht mit dem Rohr mitgedreht wird.

Auch mehrere Lanzen können vorgesehen sein, um unterschiedliche Funktionen zu erfüllen. Beispielsweise kann eine Sensorlanze mit einem Sensor wie beispielsweise einem pH-Sensor, einem Leitfähigkeitssensor oder einem Trübungssensor vorgesehen sein. Ferner kann beispielsweise eine Dosierlanze mit einem Flüssigkeitskanal und wenigstens einer Düse vorgesehen sein, um auf einer bestimmten Längenposition des Rohres Flüssigkeit zudosieren zu können. Des Weiteren kann beispielsweise eine Waschlanze mit einem Flüssigkeitskanal und wenigstens einer Düse vorgesehen sein, um das Rohr spülen bzw. Reinigen zu können.

In einer Ausführungsform weist der Rohrmantel eine Kammer für eine Temperierflüssigkeit auf. Beispielsweise ist vorgesehen, dass an der Außenseite des Rohrmantels ein Kanal angebracht ist, der z.B. helixförmig verlaufen kann. Bei dem Kanal kann es sich beispielsweise um eine Halbrohrschlange handeln, die an der Außenseite des Rohres angebracht ist, beispielsweise angeklebt oder angeschweißt ist. Alternativ kann der Rohrmantel zumindest abschnittsweise doppelwandig ausgeführt sein, und die Kammer wird durch den Zwischenraum der beiden Wände gebildet.

In einer Ausführungsform ist der helixförmig verlaufende Steg für zumindest ein Teilstück unterbrochen oder in seiner Höhe verringert. Dieses Teilstück kann sich beispielsweise über 0,25 bis 2 oder vorzugsweise über 0,75 bis 1,25 Ganglängen der Helix erstrecken. So kann ermöglicht werden, dass ein an einer Lanze befindlicher Sensor oder Aktor im Bereich dieses Teilstücks in das Kristallisationsmedium getaucht werden kann, ohne periodisch angehoben werden zu müssen oder mit dem Steg zu kollidieren.

In einer Ausführungsform umfasst der Kristallisator eine Kapselung, die das Rohr vollständig umgibt. Dabei kann vorgesehen sein, dass die Kapselung gasdicht und/oder druckfest ist. Beispielsweise kann ein Drucksensor zur Überwachung des Innendrucks der Kapselung vorhanden sein.

In einer Ausführungsform weist der Kristallisator eine Druckpumpe und/oder ein Entlüftungsventil zur Einstellung eines Drucks innerhalb der Kapselung auf.

In einer Ausführungsform weist der Kristallisator ein Fördersystem zur Bereitstellung einer Industriegasatmosphäre innerhalb der Kapselung auf. Geeignete Industriegase umfassen beispielsweise Inertgase wie Stickstoff.

Die individuellen Werte für Abmessungen der Kristallisators, Steghöhe, Ganglänge der Helix und Kammervolumen sind weitgehend von der Anwendung abhängig. Beispielhafte Werte umfassen Rohrdurchmesser von zwischen 1 und 3 m, Rohrlängen von zwischen 1 und 5 m, Steghöhen von zwischen 10 und 140 cm, Ganglängen von zwischen 5 und 50 cm und Kammervolumina von 2 bis 1600 l.

In der vorliegenden Erfindung ist vorgesehen, dass die Steghöhe zwischen 10% und 40% und vorzugsweise zwischen 20% und 30% des Rohrdurchmessers beträgt und der Gangwinkel der Helix zwischen 0,5° und 5° und vorzugsweise zwischen 1° und 3° beträgt.

Des Weiteren wird die Verwendung des Kristallisators zur Züchtung von Kristallen im Rahmen eines kontinuierlichen Prozesses durchgeführt, wobei Kristallisationsmedium kontinuierlich durch den Zulauf in das Rohr aufgegeben wird und kontinuierlich durch den Ablauf abfließt und wobei die Steghelix kontinuierlich gedreht wird.

Die Drehung der Steghelix erfolgt gemeinsam mit der Drehung des Rohres oder individuell, d.h., ohne gleichzeitige Drehung des Rohres. Nach Durchlaufen des Rohres kann das Kristallisationsmedium (mit suspendierten Kristallen) gesammelt und zentrifugiert, gefiltert und/oder dekantiert werden.

Die Drehzahl der Helix, der Durchsatz und die Verweilzeit des Kristallisationsmediums sind weitgehend von der Anwendung abhängig. Beispielhafte Werte umfassen Drehzahlen von größer 0 und 1 U/min, vorzugsweise zwischen 0,3 und 0,5 U/min, Durchsätze von 0,5 bis 100 m³/h und Verweilzeiten von zwischen 1 Minute und 10 Stunden.

Das Rohr ist während der Durchführung des Verfahrens zur Züchtung von Kristallen horizontal.

Anhand etwaig vorhandener Lanzen können auf bestimmter Längenposition des Rohres selektiv weitere Stoffe zugegeben werden oder Messungen durchgeführt werden. Beispielsweise kann eine pH-Messung durch eine an einer Lanze befestigte und in das Medium getauchte pH-Sonde erfolgen. Es kann vorgesehen sein, dass die Lanze regelmäßig entsprechend der Drehfrequenz angehoben und abgesenkt wird, um einen Steg passieren zu lassen und die Sonde dann erneut in das Medium zu tauchen.

Die Durchbrüche im ablaufseitigen Endbereich des Rohres ermöglichen einen Abfluss des Kristallisationsmediums (mit suspendierten Kristallen) aus dem Rohrinneren, beispielsweise unter Gravitationseinfluss.

Das Rohr kann beispielsweise durch Spülung gereinigt werden, wobei vorgesehen sein kann, dass die Spülung anhand einer Waschlanze erfolgt.

In einer Ausführungsform ist vorgesehen, dass die Kapsel während der Durchführung des Verfahrens unter Überdruck gesetzt wird und/oder mit einer Industriegasatmosphäre gefüllt wird. Geeignete Industriegase umfassen Inertgase wie beispielsweise Stickstoff.

Das Rohr kann auf Temperaturen von beispielsweise zwischen -80°C und 200°C temperiert werden. Zur Temperierung kann beispielsweise Temperierflüssigkeit in der am Rohrmantel vorgesehenen Kammer zirkuliert werden.

Weitere Einzelheiten und Vorteile der Erfindung ergeben sich aus den nachfolgend anhand der Figuren diskutierten Ausführungsbeispielen. In den Figuren zeigen:
- Figur 1:: einen Längsschnitt durch eine erste Ausführungsform eines Kristallisators, der in der erfindungsgemäßen Verwendung eingesetzt wird;
- Figur 2:: einen Längsschnitt durch eine zweite Ausführungsform eines Kristallisators, der in der erfindungsgemäßen Verwendung eingesetzt wird;
- Figur 3:: einen Längsschnitt durch eine dritte Ausführungsform eines Kristallisators, der in der erfindungsgemäßen Verwendung eingesetzt wird;
- Figur 4:: einen Längsschnitt durch eine vierte Ausführungsform eines Kristallisators, der in der erfindungsgemäßen Verwendung eingesetzt wird;
- Figur 5:: einen Längsschnitt durch eine fünfte Ausführungsform eines Kristallisators, der in der erfindungsgemäßen Verwendung eingesetzt wird;
- Figur 6:: einen Längsschnitt durch eine sechste Ausführungsform eines Kristallisators, der in der erfindungsgemäßen Verwendung eingesetzt wird;
- Figur 7:: einen Längsschnitt durch eine siebte nicht erfindungsgemäße Ausführungsform eines Kristallisators; und
- Figur 8:: einen Längsschnitt durch eine achte Ausführungsform eines Kristallisators, der in der erfindungsgemäßen Verwendung eingesetzt wird.

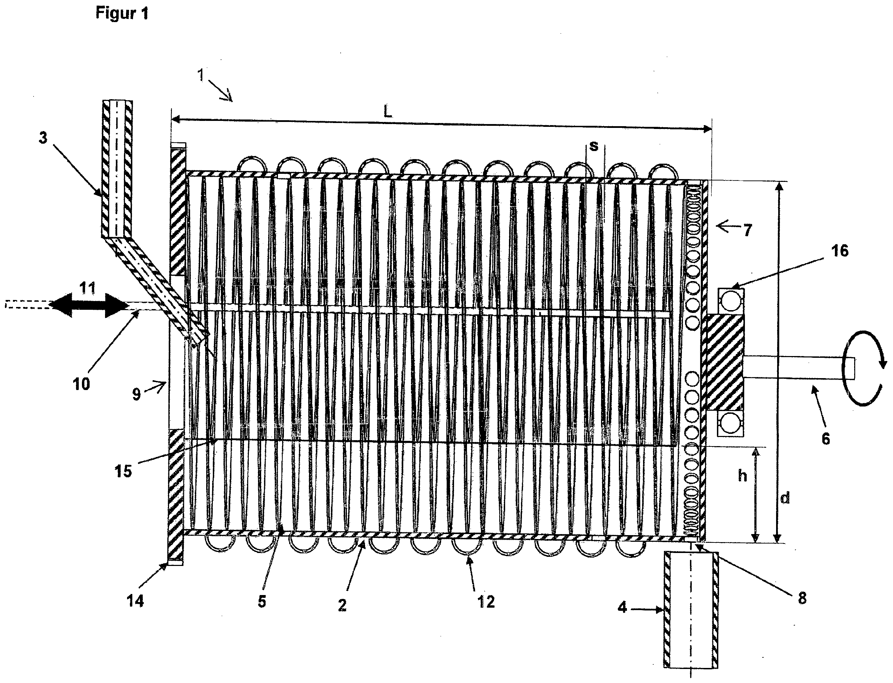

In Figur 1 ist eine erste Ausführungsform eines Kristallisators 1 im Längsschnitt dargestellt.

Der Kristallisator 1 weist ein Rohr 2 mit kreisförmigem Querschnitt auf, das um dessen im Kreismittelpunkt liegende Längsachse gedreht werden kann. An den gegenüberliegenden Endbereichen des Rohres 2 sind ein Zulauf 3 und ein Ablauf 4 für ein Kristallisationsmedium vorgesehen. An der Innenseite des Rohrmantels ist ein helixförmig um die Drehachse des Rohres verlaufender Steg 5 angeschweißt. Das Rohr und der Steg sind aus Stahl gefertigt. Am ablaufseitigen Ende des Rohres ist eine Antriebsstange 6 vorgesehen, die in der Drehachse liegt und mit einem geeigneten Antriebsmittel wie beispielsweise einem Elektromotor in Verbindung steht.

In der gezeigten Abbildung ist die Einbaulage des Rohres 1 horizontal.

Das ablaufseitige Ende des Rohres 2 ist anhand der Blende 7 verschlossen. Nahe der Blende ist im Mantel des Rohres 2 eine Vielzahl von gleichmäßig über den Umfang verteilten Bohrungen eingearbeitet, die im Betrieb des Kristallisators einen Abfluss des Kristallisationsmediums aus dem Rohrinneren ermöglichen. Die Bohrungen sind alle auf derselben Längenposition des Rohres angeordnet, d.h., im selben Abstand von den Rohrenden.

An den Ablauf 4 schließt ein in der Figur nicht näher dargestellter statischer Sammler an. An den Sammler schließt eine in der Figur nicht näher dargestellte Zentrifuge an.

Am zulaufseitigen Ende des Rohres 2 ist eine Blende 13 vorgesehen, welche einen entlang der Mantelfläche des Rohres 2 verlaufenden Damm bildet und im Zentrum eine Zugangsöffnung 9 aufweist. Der Damm ist ringförmig und die Zugangsöffnung ist kreisförmig. Der Kreismittelpunkt liegt in der Drehachse des Rohres. Die Zugangsöffnung 9 ermöglicht einen Zufluss des Kristallisationsmediums in das Rohrinnere. Der Zulauf 3 umfasst eine Leitung umfassen, die durch diese Öffnung 9 am zulaufseitigen Ende des Rohres 2 in das Rohr 2 hineinragt. Der Zulauf 3 ist nicht drehbar gelagert und wird im Betrieb des Kristallisators nicht mit dem Rohr mitgedreht.

Der Kristallisator 1 umfasst ferner eine axial verlaufende Lanze 10, die durch die Zugangsöffnung 9 in das Rohrinnere ragt. Die Lanze 10 kann einen in Figur 1 nicht näher dargestellten Sensor oder Aktor aufweisen. Die Lanze kann in horizontale Richtung 11 verschoben werden.

An der Außenseite des Rohrmantels ist eine Halbrohrschlange 12 aus Stahl angeschweißt, welche ebenso wie der Steg helixförmig verläuft und welche der Temperierung des Rohrmantels dient, indem Kühl- oder Heizflüssigkeit durch die Halbrohrschlange 12 zirkuliert werden kann. Die Zufuhr des flüssigen Kühl- oder Heizmediums kann über die ablaufseitige Welle erfolgen.

Das Rohr 2 ist ablaufseitig auf einem Kugel- oder Zylinderrollenlager 16 auf der Antriebswelle drehbar gelagert. Auf der offenen Seite kann der Behälter am Flansch 14 mit in der Figur nicht näher dargestellten Zylinderrollen in einem nicht näher dargestellten Käfig gelagert sein.

Im gezeigten Ausführungsbeispiel kann die Länge L des Kristallisators beispielsweise 3 m betragen, der Rohrdurchmesser d kann beispielsweise 2 m betragen, die Steghöhe h kann beispielsweise 50 cm betragen, die Ganglänge s kann beispielsweise 10 cm betragen und das Kammervolumen kann beispielsweise 61 I betragen.

Bei der Durchführung eines Kristallisationsverfahrens am in Figur 1 gezeigten Kristallisator 1 wird Kristallisationsmedium kontinuierlich durch den Zulauf 3 in das Rohr 2 aufgegeben, durchläuft kontinuierlich das Rohr 2 und fließt kontinuierlich durch den Ablauf 4 unter Gravitationseinfluss ab. Nach Abfluss wird das Kristallisationsmedium (mit suspendierten Kristallen) gesammelt und zentrifugiert.

Die Steghelix wird dabei kontinuierlich gedreht. Die Förderung des Kristallisationsmediums durch das Rohr beruht auf dem Prinzip der Archimedischen Schraube. Die zwischen den Stegen gebildeten Kammern verschieben sich durch Rotation der Helix kontinuierlich vom zulaufseitigen Endbereich zum ablaufseitigen Endbereich des Rohres 2 und sorgen so für eine langsame Förderung des Kristallisationsmediums durch das Rohr. Die Kristallbildung erfolgt innerhalb dieser Kammern während der Translation der Kammern durch das Rohrinnere.

Der maximale Spiegel 15 des Kristallisationsmediums entspricht der Stehhöhe h.

Die Drehzahl der Helix kann beispielsweise 0,3 U/min betragen, der Durchsatz kann beispielsweise 1,11 m³/h betragen und die Verweilzeit kann beispielsweise 100 min betragen. Die Drehzahl wird konstant gehalten, wobei ein kurzfristig höherer Eingangsvolumenstrom zu einem Überschwappen des Kristallisationsmediums auf die umgebenden Kammern führt. Die letzte Kammer läuft bei Erreichen einer Bohrung 8 leer.

Durch hydraulische Auslegung des Systems entspricht die Strömung in der Neige einer Kanalströmung und es werden Reynolds-Zahlen von mindestens 100.000 erreicht. Ein besonderer Vorteil liegt in der schonenden Behandlung des Kristallisats, wodurch sich das Verfahren zur Züchtung von nadelförmigen oder empfindlichen Kristallen eignet. Auch hohe Viskositäten können problemlos gehandhabt werden.

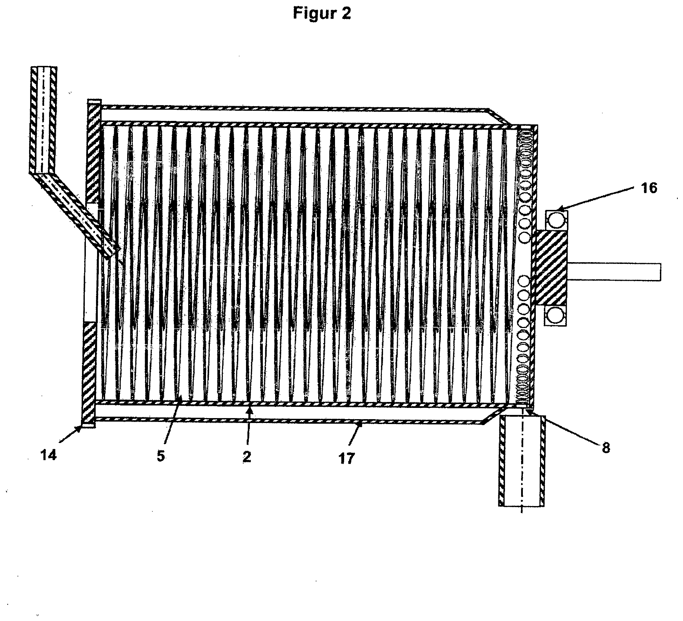

In Figur 2 ist eine weitere Ausführungsform eines Kristallisators 1 im Längsschnitt dargestellt. Im Unterschied zur Ausführungsform gemäß Figur 1 fehlt in dieser Ausführungsform die Halbrohrschlange 12.

Stattdessen ist der Rohrmantel doppelwandig ausgeführt. Eine Kammer für eine Kühl- oder Heizflüssigkeit wird durch den Zwischenraum zwischen der Innenwand des Rohrmantels und der Außenwand 17 des Rohrmantels gebildet.

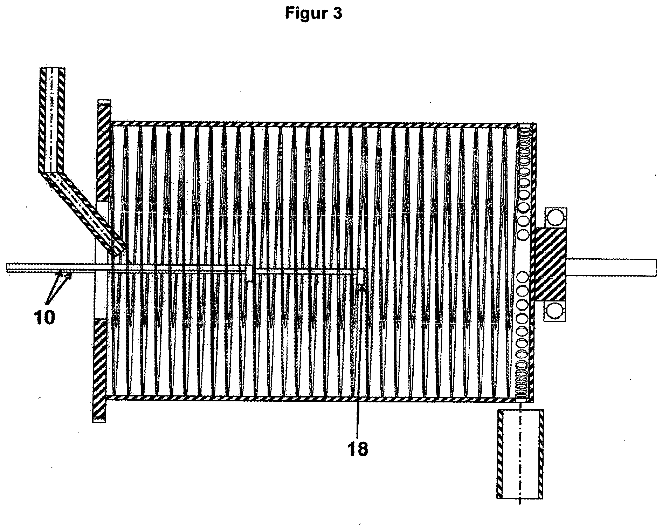

In Figur 3 ist eine weitere Ausführungsform eines Kristallisators 1 im Längsschnitt dargestellt. In dieser Ausführungsform sind zwei axial verlaufende Dosierlanzen 10 vorgesehen, die durch die Zugangsöffnung 9 in das Rohrinnere ragen. An der Spitze beider Lanzen 10 ist jeweils eine Düse 18 zur Zugabe eines Flüssigreagens vorhanden. Die Spitzen der beiden Lanzen 10 sind an unterschiedlichen Längenpositionen des Rohres angeordnet. So kann an zwei bestimmten Längenpositionen des Rohres, und somit nach einer bestimmten Verweildauer des Kristallisationsmediums im Rohr, ein Flüssigreagens zudosiert werden, um den Kristallisationsprozess zu beeinflussen.

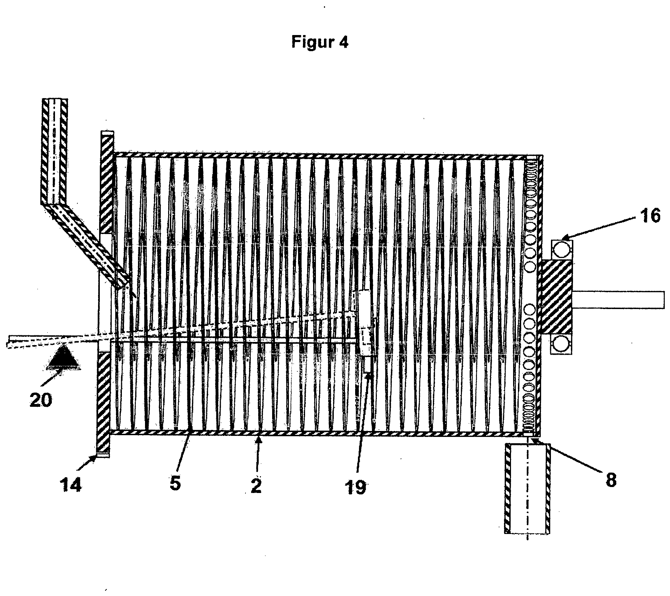

Die in Figur 4 dargestellte Ausführungsform des Kristallisators 1 umfasst eine Messlanze 10, die ebenfalls axial verläuft und durch die Zugangsöffnung 9 in das Rohrinnere ragt. An der Spitze der Messlanze 10 ist eine Sonde 19 angeordnet, bei der es sich beispielsweise um eine pH-Sonde handeln kann. Diese Lanze ist an einem außerhalb des Rohres befindlichen Kipplager 20 derart gelagert, dass sie aus der axialen Richtung gekippt werden kann, sodass die Sonde 19 angehoben und abgesenkt werden kann. So ist es möglich, die Sonde 19 beispielsweise in periodischen Abständen zu heben, um eine Kollision mit dem sich durch die Drehung des Rohres verschiebenden Steg 5 zu vermeiden. Im Betrieb wird die Sonde so regelmäßig entsprechend der Drehfrequenz des Rohres 2 bzw. der Helix 5 angehoben, um einen Steg 5 passieren zu lassen, und dann wieder in das Medium abgesenkt.

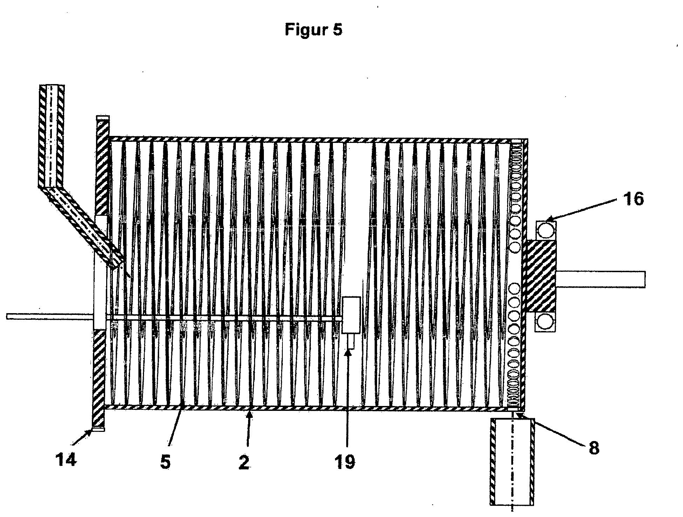

In der in Figur 5 dargestellten Ausführungsform des Kristallisators 1 fehlt das Kipplager der Messlanze 10, sodass diese nicht in periodischen Abständen aus der axialen Richtung gekippt werden kann. Um eine Kollision mit dem Steg 5 zu vermeiden, ist stattdessen vorgesehen, dass der helixförmig verlaufende Steg 5 in dem Abschnitt, in dem die Sonde 19 in das Kristallisationsmedium getaucht wird, unterbrochen ist. Der Abschnitt erstreckt sich im gezeigten Ausführungsbeispiel über genau eine Ganglänge s, wobei die optimale Länge des Abschnitts von der Ausgestaltung der Sonde 19 abhängt. Die Unterbrechung führt zu einer etwas breiteren Verweilzeitverteilung des Kristallisationsmediums, was aber in dem beobachteten Umfang in Kauf genommen werden kann.

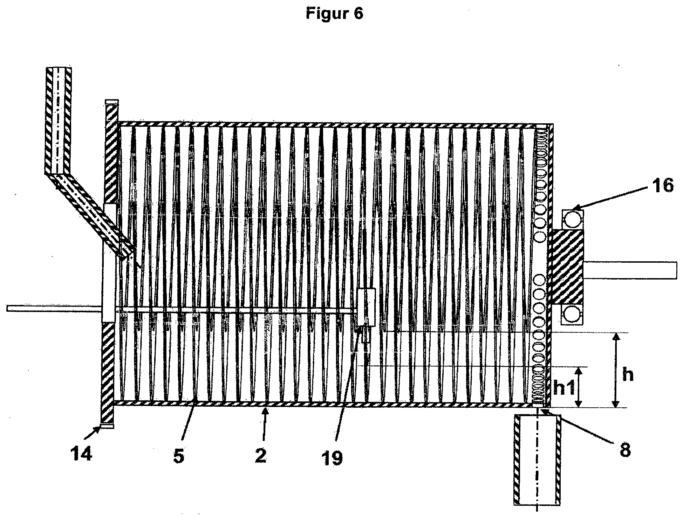

In der in Figur 6 dargestellten Ausführungsform des Kristallisators 1 ist der helixförmig verlaufende Steg 5 in dem Abschnitt, in dem die Sonde 19 in das Kristallisationsmedium getaucht wird, nicht unterbrochen sondern lediglich in deren Höhe verringert. Der höhenverringerte Abschnitt erstreckt sich auch hier über genau eine Ganglänge, und auch hier ist die optimale Länge des Abschnitts von der Ausgestaltung des Sensorkopfes abhängig. Eine breitere Verweilzeitverteilung des Kristallisationsmediums wird ebenfalls beobachtet, allerdings in etwas geringerem Umfang als bei einer vollständigen Unterbrechung der Helix 5. Die gewählte Höhe h1 des höhenverringerten Abschnittes hängt von der Ausgestaltung des Sensors 19 und der gewünschten Messtiefe ab. Beispielsweise kann die reduzierte Höhe h1 zwischen 30% und 60% der Gesamthöhe h betragen. In absoluten Zahlen ist eine reduzierte Höhe h1 von beispielsweise 20 cm denkbar.

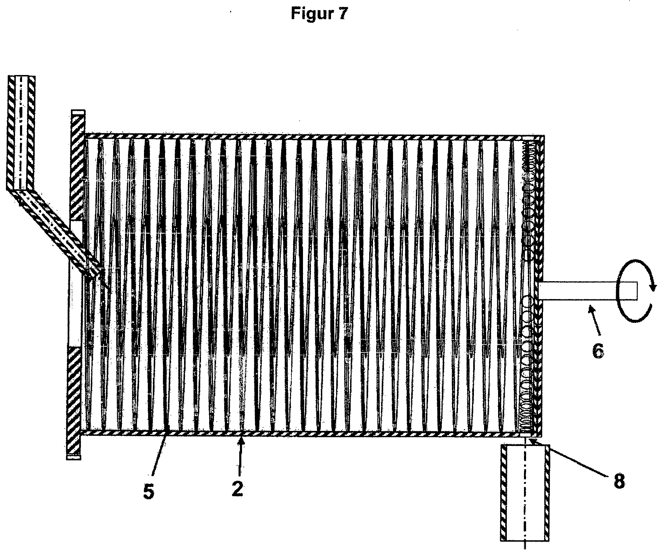

Die in Figur 7 dargestellte nicht erfindungsgemäßen Ausführungsform des Kristallisators 1 unterscheidet sich von den Ausführungsformen gemäß Figuren 1 bis 6 dadurch, dass in dieser Ausführungsform das Rohr 2 stationär gelagert ist und lediglich die Helix 5 innerhalb des Rohres 2 drehbar gelagert ist. Während der Durchführung eines . kontinuierlichen Kristallisationsprozesses unter Verwendung dieses Kristallisators 1 dreht sich daher lediglich die Helix 5 innerhalb des feststehenden Rohres 2. In dieser Ausführungsform ist die Helix 5 daher nicht fest mit dem Rohr 2 verbunden sondern vielmehr in das Rohr 2 eingelegt. Die Abmessungen der Helix 5 und des Rohres 2 sind so gewählt, dass der Außendurchmesser der Helix 5 genau dem Innendurchmesser des Rohres 2 entspricht und die Helix 5 somit passgenau in dem Rohr 2 aufgenommen ist. So wird vermieden, dass es durch einen Zwischenraum zwischen dem Rohrmantel und den Stegen 5 zu einer Verbreiterung der Verweilzeitverteilung kommt. Der Antrieb 6 ist in dieser Ausführungsform nicht mit dem Rohr 2 sondern anhand einer am ablaufseitigen Ende des Rohres 2 befindlichen Antriebsscheibe direkt mit der Helix 5 verbunden. Eine Drehlagerung des Rohres 2, wie dies im Zusammenhang mit der Ausführungsform gemäß Figur 1 beschrieben wurde, fehlt in dieser Ausführungsform.

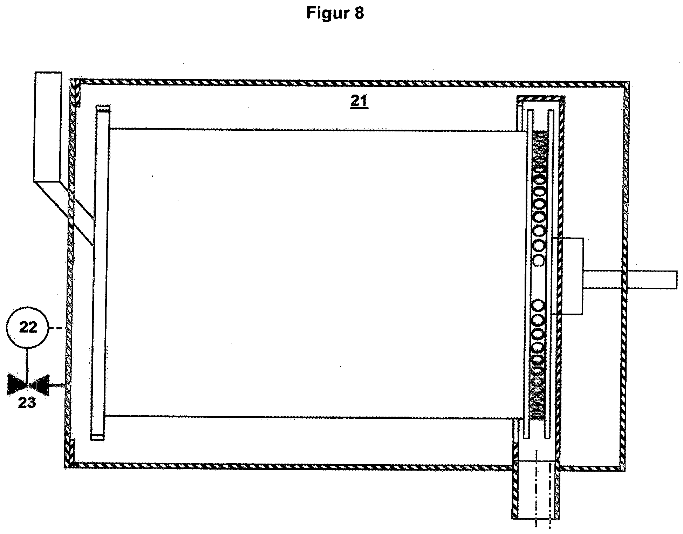

Figur 8 zeigt eine Ausführungsform des Kristallisators 1, wobei das Rohr 2 vollständig in einer druckfesten und gasdichten Kapselung 21 aufgenommen ist. Die Kapselung 21 kann während der Durchführung eines erfindungsgemäßen Verfahrens mit einen Industriegas wie beispielsweise Stickstoff gespült werden und/oder auf Über- oder Unterdruck gesetzt werden. Zu diesem Zweck können in der Figur nicht näher dargestellte Gasleitungen sowie Druck- und/oder Evakuierungspumpen vorgesehen sein. Die Kapselung 21 kann beispielsweise aus Metall oder Kunststoff bestehen. Die Kapselung 21 weist Bohrungen für den Zulauf 3 und den Ablauf 4 auf. Diese Bohrungen können, wie dies in der Figur im Zusammenhang mit dem Ablauf 4 dargestellt ist, beidseitig Bunde aufweisen, um z.B. ablaufendes Kristallisationsmedium zu führen. Im gezeigten Ausführungsbeispiel wird der Ablauf zumindest teilweise durch diese Bunde gebildet. Ferner ist in der Figur 8 ein Druckmessgerät 22 erkennbar, welches mit einem Ventil 23 gekoppelt ist. Durch eine derartige Anordnung kann bei der Durchführung des Verfahrens ggf. eine Druckregelung erfolgen.

Es ist im Rahmen der Erfindung möglich, zusätzliche Turbulenzen durch in Richtung der Längsachse am Behältermantel montierte Stromstörer oder aufgeschweißte Einbauten, wie zum Beispiel Rohre oder Stahlbleche, zu erzeugen.

Im folgenden werden industrielle Beispiele für bevorzugte Verwendungen des kontinuierlichen Kristallisators dargestellt:
1) **Kristallisation durch Änderung des pH-Werts in einem Mischer:**
   Das Ergebnis einer vorherigen Reaktion oder Mischung wird aus einem Vorlagebehälter oder einem kontinuierlichen Reaktor zum Beispiel einem Rohrreaktor in den Zustand der Übersättigung überführt. Dazu wird in einem Mischer zum Beispiel einem simplen T-Stück oder einem Venturi-Saugrohr Säure oder Lauge addiert und damit eine Übersättigung erzielt. Dieses Gemisch wird nun am Eingang des kontinuierlichen Kristallisators, der gemäß der Erfindung verwendet wird, aufgegeben.
   Weitere Säure oder Lauge kann an beliebiger Stelle im kontinuierlichen Apparat aufgegeben werden. Der Ziel-pH-Wert wird ortsfest im kontinuierlichen Kristallisators
      durch eine pH-Sonde gemessen.
   Kristallisation tritt spontan ein oder durch Zugabe von Impfkristallen. Die Impfkristalle können zum Beispiel mit der Säure oder Lauge oder in fester Form als Pulver oder in suspendierter Form im Mischer oder am Eingang des kontinuierlichen Kristallisators
      aufgegeben werden.
   Am Ende des kontinuierlichen Kristallisators fließt oder fällt das Kristallisat und Mutterlauge durch Öffnungen zum Beispiel Bohrungen in der Trommel in den nächsten Prozess-Schritt zum Beispiel Zentrifugation oder Filtration. Zum Beispiel soll die gewünschte Kristallgröße nach 17 Minuten erreicht werden. Dieses wird erzielt bei einem Volumenstrom von 1 m3/h in einem kontinuierlichen Apparat von zum Beispiel 1,5m Länge und einem Trommeldurchmesser von beispielsweise 1,0m und 50 Umdrehungen pro Stunde. Der Abstand der Stege im kontinuierlichen Apparat beträgt zum Beispiel 0,1m.
2) **Kristallisation durch Änderung des pH-Werts im kontinuierlichen Apparat:**
   In diesem Beispiel wird das Ergebnis der vorherigen Reaktion oder Mischung direkt am Eingang des kontinuierlichen Kristallisators aufgegeben.
   Zusätzlich wird Säure oder Lauge kontinuierlich addiert oder beigemischt. Weitere Säure oder Lauge kann an beliebiger Stelle im kontinuierlichen Kristallisator aufgegeben werden. Der Ziel-pH-Wert wird mit einer pH-Sonde im kontinuierlichen Kristallisator ortsfest gemessen. Kristallisation tritt spontan ein oder durch Zugabe von Impfkristallen. Die Impfkristalle können zum Beispiel mit der Säure oder Lauge oder in fester Form als Pulver oder in suspendierter Form am Eingang des kontinuierlichen Kristallisators aufgegeben werden.
   Am Ende des kontinuierlichen Kristallisators fließt oder fällt das Kristallisat und Mutterlauge durch Öffnungen zum Beispiel Bohrungen in der Trommel in den nächsten Prozess-Schritt zum Beispiel Zentrifugation oder Filtration.
   Zum Beispiel soll die gewünschte Kristallgröße nach 45 Minuten erreicht werden. Dieses wird erzielt bei einem Volumenstrom von 0,5 m³/h in einem kontinuierlichen Kristallisator von zum Beispiel 1,5 m Länge und einem Trommeldurchmesser von beispielsweise 1,0 m und 20 Umdrehungen pro Stunde. Der Abstand der Stege im kontinuierlichen Kristallisator beträgt zum Beispiel 0,1 m.
3) **Kristallisation durch Änderung der Temperatur:**
   Das Ergebnis einer vorherigen Reaktion oder Mischung wird aus einem Vorlagebehälter oder einem kontinuierlichen Reaktor zum Beispiel einem Rohrreaktor am Eingang des kontinuierlichen Kristallisators aufgegeben. Durch zum Beispiel einer Halbrohrschlange oder einem Doppelmantel wird im kontinuierlichen Kristallisator eine gewünschte Temperatur eingestellt, zum Beispiel -4°C mit einer Kühl-Sole oder 16°C mit Kühlwasser oder 130°C mit 16 bar Wasserdampf. Die Zieltemperatur wird entweder ortsfest oder am Trommelmantel gemessen und gesteuert.
   Die Kristallisation tritt spontan oder durch Zugabe von Impfkristallen ein. Die Impfkristalle können zum Beispiel in fester Form als Pulver oder in suspendierter Form am Eingang des kontinuierlichen Kristallisators aufgegeben werden.
   Am Ende des kontinuierlichen Kristallisators fließt oder fällt das Kristallisat und Mutterlauge durch Öffnungen zum Beispiel Bohrungen in der Trommel in den nächsten Prozess-Schritt zum Beispiel Zentrifugation oder Filtration.
   Zum Beispiel soll die gewünschte Kristallgröße nach 60 Minuten erreicht werden. Dieses wird erzielt bei einem Volumenstrom von 1,5 m³/h in einem kontinuierlichen Kristallisator von zum Beispiel 2,5 m Länge und einem Trommeldurchmesser von beispielsweise 2,0 m und 25 Umdrehungen pro Stunde. Der Abstand der Stege im kontinuierlichen Apparat beträgt zum Beispiel 0,1 m.
   Zusätzlich können Temperaturprofile über die Länge des kontinuierlichen Kristallisators eingestellt werden.

## Patentansprüche

1. Verwendung eines Kristallisators (1) zur Zücktung von Kristallen, wobei der Kristallisator (1) ein Rohr (2) aufweist, an dessen gegenüberliegenden Endbereichen ein Zulauf (3) und ein Ablauf (4) für ein Kristallisationsmedium vorgesehen sind, wobei ein helixförmig um eine Längsachse des Rohres (2) verlaufender und an der Innenseite des Rohrmantels anliegender Steg (5) vorgesehen ist, der derart gelagert ist, dass er um die genannte Längsachse des Rohres (2) gedreht werden kann, und wobei der Kristallisator (1) einen Antrieb (6) zur Drehung des Stegs (5) aufweist,
**dadurch gekennzeichnet,**
**dass** die Einbaulage des Rohres horizontal ist, dass die Steghöhe (h) zwischen 10% und 40% des Rohrdurchmessers (d) beträgt und dass der Gangwinkel der Helix zwischen 0.5° und 5° beträgt, dass der Steg (5) fest mit der Innenseite des Rohrmantels verbunden ist, und dass das Rohr (2) derart gelagert ist, dass es gemeinsam mit dem Steg (5) um die genannte Längsachse rotiert werden kann, wobei die drehbare Lagerung des Rohres (2) die drehbare Lagerung des Stegs (5) darstellt und wobei der Antrieb (6) zur Drehung des Rohres (2) dient.

2. Verwendung Kristallisator nach Anspruch 1, **dadurch gekennzeichnet, dass** der Steg (5) und das Rohr (2) separate Bauteile darstellen.

3. Verwendung nach einem der vorhergehenden Ansprüche, **dadurch gekennzeichnet, dass** das ablaufseitige Ende des Rohres (2) verschlossen ist, vorzugsweise mit einer Blende (7).

4. Verwendung nach einem der vorhergehenden Ansprüche, **dadurch gekennzeichnet, dass** der Rohrmantel im ablaufseitigen Endbereich wenigstens einen und vorzugsweise mehrere über den Umfang verteilte Durchbrüche (8) aufweist.

5. Verwendung nach einem der vorhergehenden Ansprüche, **dadurch gekennzeichnet, dass** das zulaufseitige Ende des Rohres (2) eine Zugangsöffnung (9) aufweist.

6. Verwendung nach einem der vorhergehenden Ansprüche, **dadurch gekennzeichnet, dass** er wenigstens eine Lanze (10) umfasst, die in axialer Richtung (11) von einem Ende des Rohres (2), vorzugsweise vom zulaufseitigen Ende des Rohres (2) in das Rohrinnere ragt, wobei diese Lanze (10) wenigstens einen Sensor (19) und/oder wenigstens ein Mittel (18) zur Flüssigkeitsabgabe aufweist.

7. Verwendung nach einem der vorhergehenden Ansprüche, **dadurch gekennzeichnet, dass** der Rohrmantel eine Kammer für eine Temperierflüssigkeit aufweist, wobei vorzugsweise vorgesehen ist, dass an der Außenseite des Rohrmantels ein beispielsweise helixförmig verlaufender Kanal (12) angebracht ist oder dass der Rohrmantel zumindest abschnittsweise doppelwandig ausgeführt ist.

8. Verwendung nach einem der vorhergehenden Ansprüche, **dadurch gekennzeichnet, dass** der helixförmig verlaufende Steg (5) für zumindest ein Teilstück unterbrochen oder in seiner Höhe (h) verringert ist, wobei sich dieses Teilstück beispielsweise über 0,25 bis 2 oder vorzugsweise über 0,75 bis 1,25 Schleifen des Stegs (5) erstreckt.

9. Verwendung nach einem der vorhergehenden Ansprüche, **dadurch gekennzeichnet, dass** er eine Kapselung (21) umfasst, die das Rohr (2) vollständig umgibt, wobei die Kapselung (21) gasdicht und/oder druckfest ist.

10. Verwendung nach Anspruch 9, **dadurch gekennzeichnet, dass** er eine Druckpumpe und/oder ein Entlüftungsventil (23) zur Einstellung eines Drucks innerhalb der Kapselung (21) aufweist und/oder dass er ein Fördersystem zur Bereitstellung einer Industriegasatmosphäre innerhalb der Kapselung (21) aufweist.

11. Verwendung nach einem der vorhergehenden Ansprüche im Rahmen eines Verfahrens zur Züchtung von Kristallen im Rahmen eines kontinuierlichen Prozesses, wobei Kristallisationsmedium kontinuierlich durch den Zulauf (3) in das Rohr (2) aufgegeben wird und kontinuierlich durch den Ablauf (4) abfließt und wobei die Steghelix (5) gemeinsam mit dem Rohr (2) kontinuierlich gedreht wird.

## Claims

1. Use of a crystallizer (1) for growing crystals, the crystallizer (1) having a tube (2), at opposite end regions of which an inflow (3) and an outflow (4) for a crystallization medium are provided, a web (5) extending helically about a longitudinal axis of the tube (2) and applied against the inner side of the tube jacket being provided, which is mounted so as to be rotatable about said longitudinal axis of the tube (2), and the crystallizer (1) having a drive (6) for rotating the web (5),
**characterized in that**
the installation position of the tube is horizontal, that the height (h) of the web is between 10% and 40% of the tube diameter (d), and that the lead angle of the helix is between 0.5° and 5°, that the web (5) is integral with the inner side of the tube jacket, and that the tube (2) is mounted so as to be rotatable together with the web (5) about the aforesaid longitudinal axis, the rotatable mounting of the tube (2) constituting the rotatable mounting of the web (5), and the drive (6) serving to rotate the tube (2).

2. Use of a crystallizer according to claim 1, **characterized in that** the web (5) and the tube (2) constitute separate components.

3. Use according to any one of the preceding claims, **characterized in that** the end of the tube (2) on the outflow side is closed, preferably by a cover (7).

4. Use according to any one of the preceding claims, **characterized in that** the tube jacket has, in the end region on the outflow side, at least one, and preferably a plurality of, apertures (8) distributed over the circumference.

5. Use according to any one of the preceding claims, **characterized in that** the end of the tube (2) on the inflow side has an access opening (9).

6. Use according to any one of the preceding claims, **characterized in that** it comprises at least one lance (10) which extends in the axial direction (11) from an end of the tube (2), preferably from the end of the tube (2) on the inflow side, toward the inside of the tube, this lance (10) having at least one sensor (19) and/or at least one liquid dispensing means (18).

7. Use according to any one of the preceding claims, **characterized in that** the tube jacket has a chamber for a temperature-control fluid, provision preferably being made that a channel (12), for example helical, is arranged on the outer side of the tube jacket, or that the tube jacket is at least sectionally double-walled.

8. Use according to any one of the preceding claims, **characterized in that** the helical web (5) is interrupted or reduced in its height (h) on at least one partial section, this partial section extending, for example, over 0.25 to 2 or preferably over 0.75 to 1.25 turns of the web (5).

9. Use according to any one of the preceding claims, **characterized in that** it comprises an encapsulation (21) completely surrounding the tube (2), the encapsulation (21) being gas-tight and/or pressure resistant.

10. Use according to claim 9, **characterized in that** it has a pressurization pump and/or a purge valve (23) for setting a pressure inside the encapsulation (21), and/or **in that** it has a conveying system for providing an industrial-gas atmosphere inside the encapsulation (21).

11. Use according to any one of the preceding claims in a method for growing crystals within a continuous process, crystallization medium being introduced continuously via the inflow (3) into the tube (2) and flowing out continuously via the outflow (4), and the helical web (5) being rotated continuously together with the tube (2).

## Revendications

1. Utilisation d'un cristalliseur (1) pour la culture de cristaux, le cristalliseur (1) présentant un tube (2), aux zones d'extrémité opposées duquel sont prévues une amenée (3) et une évacuation (4) pour un milieu de cristallisation, une nervure (5) s'étendant en hélice autour d'un axe longitudinal du tube (2) et appliquée contre le côté intérieur de l'enveloppe du tube étant prévue, laquelle est montée de manière à pouvoir tourner autour de l'axe longitudinal précité du tube (2), et le cristalliseur (1) présentant un entraînement (6) pour faire tourner la nervure (5),
**caractérisée en ce que**
la position d'installation du tube est horizontale, **en ce que** la hauteur (h) de la nervure est d'entre 10 % et 40 % du diamètre (d) du tube, et **en ce que** l'angle de pas de l'hélice est entre 0,5° et 5°, **en ce que** la nervure (5) est solidaire du côté intérieur de l'enveloppe du tube, et **en ce que** le tube (2) est monté de manière à pouvoir tourner conjointement avec la nervure (5) autour de l'axe longitudinal précité, le montage rotatif du tube (2) constituant le montage rotatif de la nervure (5), et l'entraînement (6) servant à faire tourner le tube (2).

2. Utilisation d'un cristalliseur selon la revendication 1, **caractérisée en ce que** la nervure (5) et le tube (2) constituent des composants séparés.

3. Utilisation selon l'une quelconque des revendications précédentes, **caractérisée en ce que** l'extrémité du tube (2) du côté de l'évacuation est fermée, de préférence par un écran (7).

4. Utilisation selon l'une quelconque des revendications précédentes, **caractérisée en ce que** l'enveloppe du tube présente, dans la zone de l'extrémité du côté de l'évacuation, au moins une, et de préférence plusieurs, percées (8) réparties sur la circonférence.

5. Utilisation selon l'une quelconque des revendications précédentes, **caractérisée en ce que** l'extrémité du tube (2) du côté de l'amenée présente une ouverture d'accès (9).

6. Utilisation selon l'une quelconque des revendications précédentes, **caractérisée en ce qu'**elle comprend au moins une lance (10) qui s'étend dans la direction axiale (11) à partir d'une extrémité du tube (2), de préférence à partir de l'extrémité du tube (2) du côté de l'amenée, vers l'intérieur du tube, cette lance (10) présentant au moins un capteur (19) et/ou au moins un moyen (18) de délivrance de liquide.

7. Utilisation selon l'une quelconque des revendications précédentes, **caractérisée en ce que** l'enveloppe du tube présente une chambre pour un fluide de régulation thermique, il étant de préférence prévu qu'un canal (12), par exemple hélicoïdal, soit disposé sur le côté extérieur de l'enveloppe du tube, ou que l'enveloppe du tube soit réalisée au moins par sections à double paroi.

8. Utilisation selon l'une quelconque des revendications précédentes, **caractérisée en ce que** la nervure hélicoïdale (5) est interrompue ou réduite dans sa hauteur (h) sur au moins un tronçon partiel, ce tronçon partiel s'étendant par exemple sur 0,25 à 2 ou de préférence sur 0,75 à 1,25 spire(s) de la nervure (5).

9. Utilisation selon l'une quelconque des revendications précédentes, **caractérisée en ce qu'**elle comprend un capsulage (21) entourant complètement le tube (2), le capsulage (21) étant étanche aux gaz et/ou résistant à la pression.

10. Utilisation selon la revendication 9, **caractérisée en ce qu'**elle présente une pompe de pressurisation et/ou une soupape de purge (23) pour régler une pression à l'intérieur du capsulage (21), et/ou **en ce qu'**elle présente un système de transport destiné à fournir une atmosphère de gaz industriel à l'intérieur du capsulage (21).

11. Utilisation selon l'une quelconque des revendications précédentes dans le cadre d'un procédé de culture de cristaux dans le cadre d'un processus continu, un milieu de cristallisation étant introduit de manière continue par l'amenée (3) dans le tube (2) et s'écoulant de manière continue par l'évacuation (4), et la nervure hélicoïdale (5) étant mise en rotation de manière continue conjointement avec le tube (2).
